# EUROPEAN PATENT SPECIFICATION

(11) **EP 1 708 261 B1**
(45) Date of publication and mention of the grant of the patent: **17.12.2014**
(21) Application number: 04727496.4
(22) Date of filing: 15.04.2004
(51) Int. Cl.: H01L 23/427, F28D 15/02, H05K 7/20, G06F 1/20

(54) **Heat pipe radiator for a heat-generating component**
Wärmerohr für ein wärmeerzeugendes Bauteil
Radiateur avec caloduc pour un composant électronique générant de la chaleur

(30) Priority: 08.01.2004 CN 10000163
(43) Date of publication of application: 04.10.2006
(73) Proprietor: Yang, Hongwu, Liaoning 116023 (CN)
(72) Inventor: Yang, Hongwu, Liaoning 116023 (CN)
(74) Representative: Beetz & Partner
(86) International application number: PCT/CN2004/000356
(87) International publication number: WO 2005/071747

(56) References cited:
- CN-Y- 2 483 756
- CN-Y- 2 566 460
- JP-A- 10 185 466
- US-A- 4 335 781
- US-A- 4 633 371
- US-A- 5 647 429
- US-A- 5 998 863
- US-A- 6 005 772
- US-A1- 2001 004 934
- US-A1- 2002 056 908
- US-A1- 2002 189 791
- US-B1- 6 321 831
- US-B1- 6 418 017
- US-B1- 6 588 498

## Description

### Field of the Invention

The present invention relates to a radiator, especially an integrated heat pipe radiator formed by adjusting the arrangement of thermal fins wick and the overall heat pipe and having a three dimensional condensable heat transfer network. The radiator can be used for the heat transfer of electronic components. A heat pipe radiator as described in the preamble portion of patent claim 1 is known from US 4 633 371 A.

### Background of the Invention

With the rapid development of electronics and electric power technologies, especially the significantly increased integrity of integrated circuits, the heat transfer of electronic components has become one of the critical problems that limit the operating speed and output power of electronic appliances.

For example, the integrity of a computer CPU was increased proximally 20,000 times within 30 years, and the heat flow generated has reached an extent of 100W/cm². Moreover, this value will increase continuously, with the increase of the integrity of integrated circuits.

It is well known that the reliability and life time of a computer are closely related to the working temperature thereof, and that the higher the integrity, the more heat energy is generated. It is also known that the normal internal working temperature of a computer chip is no more than 130°C, and the reliability will be decreased by 3.8% as a result of every degree increase. If the heat energy can not be dissipated in time, the working reliability of a computer can not be guaranteed and the computer may operate abnormally. As for computer research and development organizations, if they can not effectively solve the problem of the heat energy generated by chips and other electronic components during working, it is impossible for them to develop data processing devices with higher speed, higher power and smaller volumes. Nowadays, the common method for heat transfer of computers and other electronic components comprises arranging comb-like heat transfer plates made of an aluminium alloy on the bodies of chips or other electronic components so as to acquire a larger heat transfer area. At the same time, the heat energy is dissipated by cooling fans, so as to decrease the temperature. This method has the advantages of simplicity and cheapness, but it is only applicable to the heat transfer of components used in low calculating speed, low power electronic appliances.

In 1998, US Sandia National Laboratories applied the heat pipe technology to the heat transfer of computer chips and obtained good results.

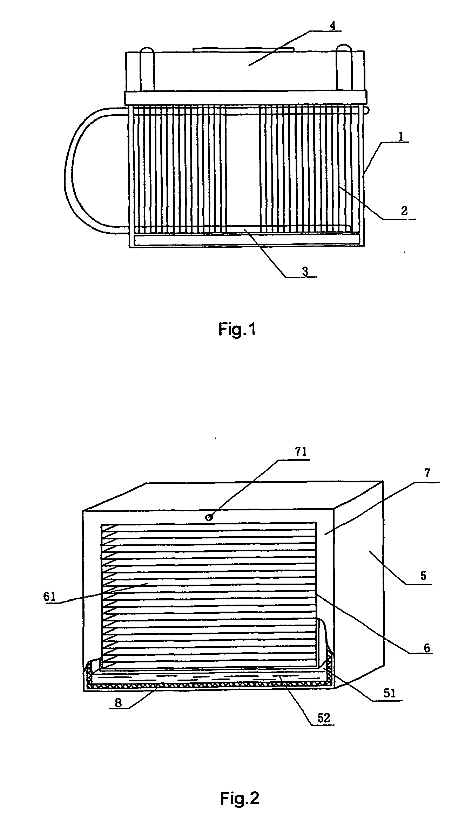

Fig.1 shows a radiator device with a heat pipe currently used. It comprises an enclosure body 1. The bottom plate of the enclosure body 1 is mounted with densely distributed thermal fins 2 made from thin metal pieces. Heat pipes 3 (the number may be two or three) are laid on the bottom plate of the enclosure body 1. The pipes 3 pass through the bottom of the thermal fins, extend upwards, then are curved by 180 degrees and get into the top of the thermal fins 2. All the thermal fins 2 are tightly attached to the heat pipe 3. A working liquid, which is vaporizable when heated and condensable when cooled, is disposed in the heat pipes 3. When the enclosure body 1 is mounted on a chip, the heat energy generated by the chip causes the working liquid in heat pipes laid on the bottom plate in the enclosure body 1 to be evaporated. The heat energy enters the heat pipes 3 located on the top of the thermal fins 2 along with the evaporated working liquid, and condensable due to low temperature, while heat energy transferred outside through the thermal fins 2. If an enhanced cooling fan 4 is mounted on the top of the thermal fins 2, the heat energy will be transferred outward more easily.

Because heat pipes have extremely high heat transfer efficiency, the heat energy generated by chips can be rapidly transferred to distal thermal fins, so as to achieve the heat transfer. This method of heat transfer has higher heat transfer efficiency than that of prior comb-like heat transfer plates. As a rule, the temperature in a position distal to a chip is lower and the temperature in a position proximal to the chip is higher. This phenomenon of temperature gradient wastes a mass of heat transfer area, which will not obtain higher transfer efficiency. However, heat pipes can overcome the disadvantage of poor heat transfer effect of the comb-like heat transfer plates.

Though the heat pipe radiator device in Fig. 1 shows better heat transfer effect, the thermal fins can not be thin enough, when considering the deficiency of the structure (there are high resistances between heat source and bottom plate, between heat pipe and bottom plate, as well as heat pipe and fins) and the strength of the radiator. However, thicker fins will not only waste material and occupy the limited space, but also can not acquire larger thermal transfer area. Therefore, this method can not meet the heat transfer requirements of super large integrated circuits, high power electronic devices and high speed chips, which limits their application and development to some extent.

In a similar way, a chip radiator device is known utilizing the heat pipe theory. It is a hollow enclosure, with a working liquid infused inside. Multiple comb-like thermal fins are extendedly disposed on the surface of the enclosure. When the hollow enclosure is mounted on a surface of a chip, the heat energy of the chip is transferred into the hollow enclosure. The evaporated working liquid transfers the heat energy to the surface of the hollow enclosure, and the heat energy is then dissipated outside by the multiple comb-like thermal fins. This chip radiator shows better heat transfer efficiency than that of the heat pipe radiator device shown in Fig. 1. But it is still limited by the inside evaporation space and the size of thermal transfer surface, and can not sufficiently meet the heat transfer requirement of modem high speed chips and larger scale integrated circuits in research and development.

US 6 005 772 A discloses a cooling apparatus. A radiating part mounted on a refrigerant tank is made by stacking refrigerant tubes and fins alternately. A first header and a second header are provided at the ends of the refrigerant tubes. When the cooling apparatus is used in a vertical attitude, the first header is positioned above the liquid surface of refrigerant inside the refrigerant tank, and the second header is positioned below the liquid surface.

US 6 588 498 B1 discloses a thermosiphon for cooling an electronic device having a mean width of dimension "b", which comprises a boilerplate having a top surface and including a plurality of pyramid shaped fins projecting upwardly from the top surface.

US 6 321 831 B1 discloses a cooling apparatus which includes a refrigerant tank containing boiling and condensing refrigerant and a radiator for cooling the refrigerant. The radiator is connected to the refrigerant tank on a front surface thereof, and hot objects to be cooled are attached to a heat-receiving surface formed on a rear surface of the refrigerant tank. The refrigerant is circulated in the apparatus so that the refrigerant is vaporized in the refrigerant tank and condensed in the radiator. The radiator is connected to the refrigerant tank by inserting a pair of header tanks thereof into the refrigerant tank. The insertion length is controlled to obtain good heat conductivity between the radiator and the refrigerant tank and to avoid deformation of a radiator fin contacting the refrigerant tank. Holes for mounting a substrate carrying the hot objects may be made on enlarged portions of a cover plate closing the refrigerant tank.

US 2002/189791 A1 discloses a liquid cooler including a body and a cover attached on the body. The body includes a base with a first cavity accommodating liquid, a central hollow cylinder having a passage in communication with the first cavity, and a plurality of vertical tubes in communication with the first cavity. A plurality of fins extends outwardly from the hollow cylinder. The cover defines a second cavity in communication with the passage and the tubes. The liquid within the first cavity is heated by a heat-generating electronic device and moved to the second cavity through the tubes. Heated liquid which has reached the second cavity flows down through the passage along an inner surface of the hollow cylinder and returns back to the first cavity. The heated liquid is cooled by the fins conducting heat away from the hollow cylinder.

US 4 633 371 A discloses a heat pipe heat exchanger for large scale integrated circuits. The heat pipe means is mounted on the substrate which supports the integrated circuit. The heat is conducted by the heat pipe means away from the integrated circuit to a surface area for dissipating heat. A plenum supplies a cooling medium across the surface area of the heat pipe means for removing the heat. An enclosing means for enclosing the surface area of the heat pipe means forms channels across the surface area for receiving the cooling medium supplied from the plenum.

Accordingly, this document discloses a heat pipe radiator for heat generating electronic components comprising a tubular enclosure, a tubular thin-walled fluid channel arranged in the enclosure with the edge hermetically connected with that of the enclosure by an end panel, thermal fins are fixedly arranged in the tubular thin-walled fluid channel.

US 5 998 863 A discloses a cooling apparatus including a refrigerant tank to which a semiconductor device is attached, a connection chamber which is open to the central portion of the refrigerant tank on the side opposite to the side where the semiconductor device is mounted, a first tube (a first radiator) having one end in communication with the connection chamber and the other end in communication with one end of the refrigerant tank, a second tube (a second radiator) having one end in communication with the connection chamber and the other end in communication with the other end of the refrigerant tank, and refrigerant contained in the refrigerant tank.

US 2002/056908 A1 discloses an apparatus which can dissipate heat and include a top wall including a plurality of hollow fins, a bottom wall, and a plurality of side walls that define an inner cavity. A plurality of condenser regions can be located within the inner cavity, and each one of the plurality of condenser regions can be located within one of the plurality of hollow fins. The inner cavity also can include an evaporator region adjacent said bottom wall.

US 2001/004934 A1 discloses a compressed mesh wick, a method for manufacturing the same, and a plate-type heat pipe including a compressed mesh wick. This document specifically discloses stacking multilayer woven metal meshes which are strip-shaped and repeatedly folded.

US 6418017 B1 discloses a heat dissipating chassis member. It specifically discloses meshes, powder sintered wicks, grooved wicks.

US 5647429 A discloses coupled, flux transformer heat pipes. It speciflcally discloses wicks having pores, wrapped screen wicks and composite wicks.

Therefore, there is a problem how to utilize the heat pipe theory to design and commercially produce radiators with high heat transfer efficiency to meet the higher requirements of heat transfer of electronic components, which has become one of the problems that should be solved imminently by the persons skilled in the field.

### Summary of the Invention

The object of this invention is to overcome the problem of conventional radiators which can not meet the present requirements of heat transfer of electronic components and aren't able to be conditioned for the rapid development of modern electronic technology. In other words, this invention intends to provide a heat pipe radiator for heat generating electronic components, which takes advantage of heat pipe theory that working liquid can rapidly take away heat energy.

This object is accomplished with a heat pipe radiator as claimed in claim 1. Features of preferred embodiments of the invention are claimed in the dependent claims.

Due to the arrangement of cooling network in three dimensions, the present invention achieves an optimized match combination of heat energy generated by the heat resources and heat transfer area, and thus provides a new means of solution to solve the heat transfer of the electronic components.

According to the present invention, the thermal fins increase the heat transfer area significantly. The effect of the heat-transfer by the thermal fins will be even better when a cold wind blows through the tubular thin-walled fluid channel.

During production, the shape of the enclosure will be formed as a rectangular, circular or hexagonal tube or in any other shapes according to the practical requirement.

The wick can be made from multilayer fiber woven meshes, or can be made from terrace multilayer metal meshes. A plate having microcellular structure by powder sintering may also be used. The wick can be coated on the surface of the inner wall of the enclosure by adhering or welding.

The wick can be produced by another means. The wick can be a strap made from metal or organic sheets by continuously and repeatedly bending or curving. Some pores are formed at the surface of the sheets, which are circumferentially attached to the inner wall of the enclosure by welding or adhering. The wick produced in this manner not only has the property that the wick absorbs the working liquid described above, but also can assist heat transfer and thermal conduction itself, due to its excellent thermal conductivity itself. This wick allows the working liquid far from the heat source to be evaporated directly and rapidly, so that the thermal conductive rate is increased and thus the heat transfer efficiency of entire heat pipe radiator of heat generating electronic components is significantly improved.

In these technical solutions, one or more tubular thin-walled fluid channels may be made depending on the actual requirements. A communicated sealed space is formed between the tubular thin-walled fluid channel and the inner wall of the enclosure and between the outsides of the multiple tubular thin-walled fluid channels by hermetically connecting the edges of end panels to the edges of multiple tubular thin-walled fluid channels and the edges of enclosure.

When the volume of enclosure and the number of the layers of thermal fins are determined, multiple tubular thin-walled fluid channels will decrease the total heat transfer area of the thermal fins, but will increase the volume of sealed space and benefit the evaporation heat transfer of the working liquid. The determination of the number of tubular thin-walled fluid channels depends on the match requirement between the heat energy generated by the heat source and the heat energy dissipated. Therefore, the optimized match design can be achieved by adjusting the numbers of tubular thin-walled fluid channels. In addition, the limited space can be effectively utilized by adjusting the sectional shape of the tubular thin-walled fluid channels, such as rectangle or circle or hexagon or other shapes, such that a better match value of the rate of the volume in tubular thin-walled fluid channels for cooling fluid to flow through and the volume in sealed space can be achieved. Experiments show that the volume for cooling fluid to flow through should be more than or equal to 2 times of the volume of the sealed space.

The tubular thin-walled fluid channel can be made of metal material with excellent thermal conductivity. In order to secure the thermal fins, support rods or support plates can be arranged in the tubular thin-walled fluid channels. The support rods or support plates pass through the thermal fins and are fixed to the inner wall of said the tubular thin-walled fluid channels So that the thermal fins are tightly connected with the support rods or support plates. Thin-wall heat pipes made of metal material can also be provided in the tubular thin-walled fluid channels. The thin-wall heat pipes pass through said thermal fins and are tightly connected with said thermal fins. The both ends of the thin-wall heat pipes are fixed to the inner wall of the tubular thin-walled fluid channels and communicated with the sealed space. Therefore, the thin-wall heat pipes can not only fix the thermal fins, but also transfer the heat energy to the thermal fins. The effect is equal to the increased volume of the sealed space and the increased area for transferring heat energy to the thermal fins. As a result, excellent efficiency of heat transfer is obtained.

In these solutions, the end panels are critical components for sealing the sealed space. In order to reliably secure the sealing and to be easy for production, flanges useful for welding or adhering to the inner wall of enclosure and the outer surfaces of tubular thin-walled fluid channels can be outwardly formed from the surface edges of the end panels inner wall, which can be arranged inward or outward to the sealed space. The arrangement of flanges can improve the strength of heat pipe radiator for heat generating electronic components, and are suitable for producing in quantity.

The thermal fins are made from sheet metals. The thermal fins can be wavy or can be a thermal fins group formed by continuously folding the sheet metals according to "Z" shape. Some penetrating holes can be formed at the surface of the thermal fins for cooling fluid to flow through. According to the invention, some upright thorns that cause the turbulent flow of the cooling fluid are vertically arranged at the surface of the thermal fins so as to further improve the heat transfer effect.

In order to further increase the heat transfer efficiency, an enhanced cooling fan is provided outside the tubular thin-wall fluid channel of the heat pipe radiator for heat generating electronic component. For this propose, a guiding cover, which is used to introduce the cold flow blew from the cooling fan into the tubular thin-wall fluid channels, is suitably mounted at the edge of enclosure. The shape of the guiding cover is similar to that of the enclosure or the tubular thin-wall fluid channels.

To make full use of the heat transfer capability of the working liquid in the sealed space and of the integrated heat-dissipating capability of the thermal fins, outer tubular fluid channels made of material with excellent heat conductivity are fixedly attached to the outside surface of the enclosure. The axial lines of the outer tubular thin-wall fluid channels are parallel to those of the said tubular thin-wall fluid channel. Thermal fins are provided at the internal walls of the outer tubular fluid channels. The thermal fins in outer tubular fluid channels absorb the heat energy of the outside surface of the enclosure, so that the heat transfer area outside the enclosure is increased significantly. Thus the heat transfer rate is speeded up and heat efficiency is improved.

The technical solutions can be used to dissipate heat energy from multiple heat generating electronic components simultaneously. At the same time, in order to increase the heat transfer efficiency from heat generating electronic components to the sealed space, one or more heat-conductive plates, which are able to be tightly attached to the heat-dissipating surface of the heat generating electronic components, are fixedly arranged on the enclosure. The heat-conductive plates are embedded at the surface of the enclosure. Alternatively, a special concave is opened at the surface of the enclosure and the heat-conductive plate is used as the bottom surface of the special concave. The heat-dissipating surface of the outer heat generating electronic component can be engaged into the special concave, and tightly attached to the heat -conductive plate. The heat-conductive plates are made from metal plate or organic soft plate material with excellent thermal conductivity. The heat plates can be made in rectangle, circle, or any other matching shapes according to the shapes of the heat-dissipating surfaces of the heat generating components.

In order to meet the requirements of higher heat transfer of the chips from the rapid development of super large scale integration technology, the present invention further provides a technical solution to directly dissipate heat from the integrated circuits themselves. At the same time, the technical solution provides good ways to directly dissipate heat from high power transistors and high frequency transistors. The detailed solution is as follows: based on the technical solutions described above, one or more holes are formed at the enclosure and a base plate for components with size matching for the hole is embedded. The base plate for components is hermetically connected with the enclosure at the circumferential edge thereof. The integrated electronic circuit or inner chips of the electronic components is provided on the surface of the base plate located in the sealed space. Multiple pins of the integrated electronic circuit or inner chips of electronic components can be arranged on the surface of the base plate for components located outside the enclosure.

The wick is applied on the inner chips of the integrated electronic circuit or electronic components. The working liquid is an electrical insulater material and chemically, electrically compatible with the material of inner chips of the integrated electronic circuit or electronic components.

In this technical solution, the base plate can be the chip base board of the integrated circuits, and super large integrated circuits at its surface is directly arranged in the sealed space and directly contacted with the working liquid, so that the transfer of heat energy is rapid and has no thermal resistance. Therefore, the capability to dissipate heat energy from chips is improved as much as possible, the working stability is ensured and the life time of chips is prolonged. In a similar way, the bottom board of the high power transistors can also be formed as the base plate of components. The P-N junctions fixed on the surface of the bottom board of high power transistors is also directly contacted with the working liquid. Thus, the phenomenon that the heat energy can only be exported by the insulater material of junction base with low heat transfer efficiency of conventional transistors is eliminated, which significantly increases the heat transfer efficiency of transistors and prolonged the life time of transistors, especially the reliability and life time of high power transistors and high frequency transistors is improved.

It can be known from the above mentioned technical solutions that, based on the theory of heat pipe transferring heat, the present invention makes the thermal fins ultra-thinned, with a high density and obtains much more heat transfer area than that of conventional heat pipe devices, because a three dimensional heat transfer network is formed by forming a sealed space for the evaporation heat transfer of working liquid by arranging tubular thin-walled fluid channels in the tubular enclosure and making use of the thermal fins provided in the tubular thin-walled fluid channels. The optimized match is obtained between the heat energy generated by the electric components and the heat transfer efficiency of radiator. The heat transfer efficiency of radiator is improved without increasing the volume of the radiator. Moreover, the present invention is featured by its simple structure, high heat transfer rate, uniform heat transfer, easy to use and high working reliability, and it can be manufactured in various forms to meet the requirements of different devices according to the actual situation of the electric components.

In addition, the present invention also provides effective solutions of direct heat transfer for the problem of heat transfer of present and future super large intergraded circuits and various heat generating electronic components.

### Brief Description of the Drawings

Fig.1 is a structural schematic view of a heat pipe radiator device currently used;
Fig.2 is a structural schematic view of the heat pipe radiator for heat generating electronic components according to the present invention;
Fig.3 is a structural schematic view of an end panel of the heat pipe radiator shown Fig.2;
Fig.4 is a structural schematic view of an exemplary embodiment of the fluid sucking wick according to the present invention;
Fig.5 is a structural schematic view of another exemplary embodiment of the fluid sucking wick according to the present invention;
Fig.6 is a structural schematic view of an exemplary embodiment of the flaky fluid sucking wick according to the present invention;
Fig.7 is structural schematic view of an another exemplary embodiment of the flaky fluid sucking wick according to the present invention;
Fig.8 is a structural schematic view of a further exemplary embodiment of the flaky fluid sucking wick according to the present invention;
Fig. 9 is a structural schematic view of an exemplary embodiment according to the present invention;
Fig. 10 is a structural schematic view of another exemplary embodiment according to the present invention;
Fig. 11 is a structural side view of the exemplary embodiment shown in Fig. 10;
Fig. 12 is a schematic view of another connection method of the end panels according to the present invention;
Fig. 13 is a structural schematic view of an exemplary embodiment of the thermal fins according to the present invention;
Fig. 14 is a structural schematic view of another exemplary embodiment of the thermal fins according to the present invention;
Fig. 15 is a structural schematic view of an exemplary embodiment with outer tubular fluid channels according to the present invention;
Fig. 16 is a structural schematic view of an exemplary embodiment with reduced thermal resistance according to the present invention;
Fig. 17 is a structural schematic view of an exemplary embodiment capable of eliminating thermal resistance and directly dissipating heat energy according to the present invention.

### Detailed Description of the Preferred Embodiments

The present invention is further described hereinafter with detailed embodiments, in reference to the accompanying drawings.

Figure 2 is a theory structural schematic view of a heat pipe radiator of heat generating electronic components provide by the present invention. This radiator comprises a tubular enclosure 5(it's rectangular in this figure, but may be made in other shapes). A tubular thin-walled fluid channel 6 is disposed inside the enclosure 5. Also, the said tubular thin-walled fluid channel 6 is rectangular. The tubular thin-walled channel 6 and the enclosure 5 are hermetically connected along the edges by two front and back parallel end panels 7so that a sealed space 51 is formed between the inner wall of enclosure 5 and the outside of tubular thin-walled fluid channel 6. This sealed space 51 is evacuated and its inside is infused with a working fluid 52, which is vaporizable when heated and condensable when cooled.

The tubular thin-walled fluid channel 6 is made from sheet metals having excellent thermal conductivity, and multilayer thermal fins 61 are securely attached inside. Multilayer thermal fins 61 are arranged densely and in parallel, with their edges connected to the inner wall of tubular thin-walled channel 6. When cooling liquid passes through the tubular thin-walled channel 6, heat energy is dissipated through the thermal fins 61.

Inside the sealed space 51, a fluid sucking wick 8 is coated around the internal surface of enclosure 5. The inside and surface of the fluid sucking wick 8 have interstices, which are capable of causing capillary forces to allow liquid absorbed on its surface and spread through its surface. The fluid sucking wick 8 can be affixed on the internal surface of the enclosure 5 by welding or adhering, with part of which immersed in the working liquid.

An infusion hole 71 used to vacuum the sealed space and infuse the working liquid is provided on the end panel 7. This infusion hole 71 is sealed off after the sealed space is vacuuming and infused with the working liquid 52.

When the heat pipe radiator of the electric component above described is in use, it is mounted on a surface of a heat generating electronic component (e.g. CPU chip). The heat energy produced by the heat generating electronic component is transferred to working liquid 52 through the bottom of the enclosure 5, and then the working liquid 52 is evaporated and the unheated portion flows to the evaporated portion to compensate. The evaporated working liquid 52 moves upward along the inside of sealed space 51, and performs heat exchanging with the outside of tubular thin-walled fluid channel 6. The heat energy is transferred to multilayer thermal fins 61. The evaporated working fluid giving off heat energy 52 is condensable to be liquid again due to decreased temperature, and falls to the original position to continuously compensate the evaporated portion. Thus, a circular movement of phase change of working fluid 52 is formed in the sealed space 51. During this circular movement of phase change, the heat energy of heat generating electronic component is dispelled rapidly.

Inside the tubular thin-walled fluid channel 6, compared with the heat transfer area of heat generating electronic component, the densely arranged multilayer thermal fins 61 acquired much more heat transfer area, so as to ensure the heat energy dissipated timely.

When the electronic component is working during movement (e.g. transportation) or at the status of incline or upside down, working liquid 52 deviates from the position of heat generating electronic component. Then the wick 8 absorbs the working liquid 52 by using the capillary forces produced by its inside interstices, and allows the working liquid 52 to spread to the position of heat generating electronic component to provide evaporation heat transfer. Thus, it is ensured that circular movement of phase change of the working liquid will not be interrupted.

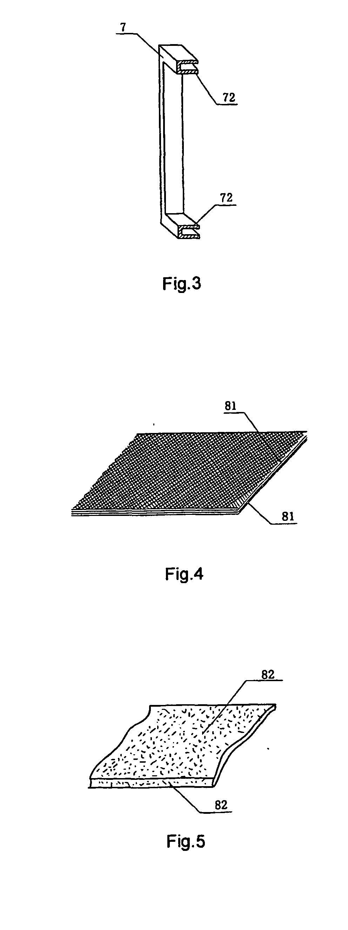

The shape of end panel 7 is adopted from the shape formed between the outside of tubular thin-walled fluid channel 6 and the inside of enclosure 5. In the above embodiment, the shape of the end panel 7 is a rectangular-framed. For the sake of easy assembly, fastness and good sealing, the section of the end panel 7 can be concave, as shown in Fig.3. In Fig.3, a flange 72 is protuberantly provided around the surface edge of the end panel 7 toward the inside of said sealed space. The end panel 7 can be easily welded or adhered to the inside of enclosure or the outside surface of the tubular thin-walled fluid channel by this flange 72. It has the advantages of easy procession and good sealing. The protruding direction of the flange 72 may be toward the outside of sealed space, but it will reduce the volume of the sealed space.

The wick 8 can be produced in many forms. Fig. 4 shows a wick produced by welding stacked multilayer metal meshes 81. Between the multilayer metal meshes 81 and the multilayer metal meshes 81 themselves have abundant interstices, which can result in better liquid sucking effect.

Fig. 5 is a part view of porous wick produced by a powder sintering process. This wick makes use of micro-pores 82 inside and at the surface thereof to produce capillary forces to suck liquid.

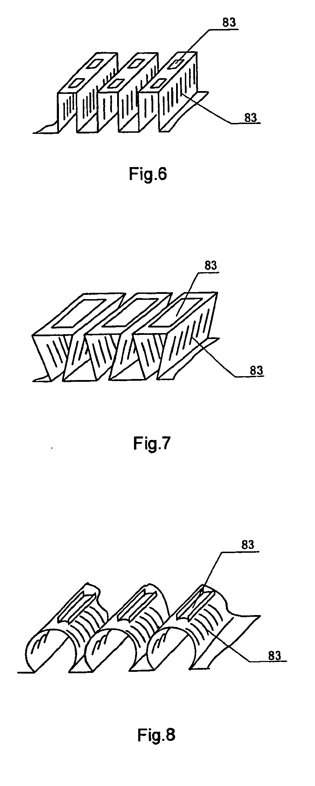

Fig. 6 shows a strip-shaped wick, which is made by continuously bending sheet metals having excellent thermal conductivity to and for according to its "U" shape. There are many "U" shaped grooves are formed in the strip-shaped wick. Pores 83 are opened at the surface of sheet metals of this strip-shaped wick. The pores 83 can be rectangular or circular aperture opening, which can be arranged inward or outward. This strip-shaped wick can be welded to inner wall of enclosure. Compared with other wicks, it has good capillary sucking force. Moreover, because it is an excellent thermal conductor itself, it can assist thermal conduction, rapidly transfer heat energy to the distal working fluid and perform evaporation heat transfer at larger area through the pores 83 at the surface thereof. Therefore, compared with wicks of multilayer metal meshes and porous wick produced by powder sintering process, it achieves a better heat transfer effect. The strip-shaped wick made from sheet metals can also be the strip-shaped wick made by continuously bending sheet metals having excellent thermal conductivity to and fro according to "V" shape, as shown in Fig. 7; or by continuously bending sheet metals having excellent thermal conductivity to and fro according to "Ω" shape, as shown in Fig.8. In Fig.7 and Fig. 8, pores 83 are formed at the surfaces of these two strip-shaped wicks, and thus the surfaces can be used for working liquid to be evaporated.

Pores 83 and multiple grooves of "U" shape, "V" shape or "Ω" shape naturally formed in Fig.6, Fig.7 and Fig.8 can allow the working fluid to spread inside easily.

In order to facilitate the evaporation and spreading of working fluid, the end openings of grooves of "U" shape, "V" shape and "Ω" shape can be sealed off.

Beside the function of transporting liquid of conventional wicks by capillary forces, these strip-shaped wicks made from sheet metals also have two special functions, which make the present invention more effective. The functions are as follows:
Firstly, when the wicks are welded to the inner wall of the enclosure, they can significantly improve the strength of the enclosure because of the strong structure of themselves. Thus, the enclosure can be made of thin material, which can not only further reduce the thermal resistance and speed up the conduction, but also decrease the weight of the enclosure, without lowering the mechanical strength of the enclosure. It will be important for the development, production and application of future miniaturized electronic devices, especially when the electronic devices used in sophisticated aviatic apparatus.
Secondly, because the wicks are formed by bending the sheets and have plenty of pores at the surface thereof, when the wicks are welded to the enclosure and transfer the heat energy, as a rule the temperatures of the edges of turning and pores are higher, which allows the working liquids of these positions to be boiled more easily, and result in an effect of enhanced boiling. Thus the heat energy can be dissipated more rapidly through the boiling.

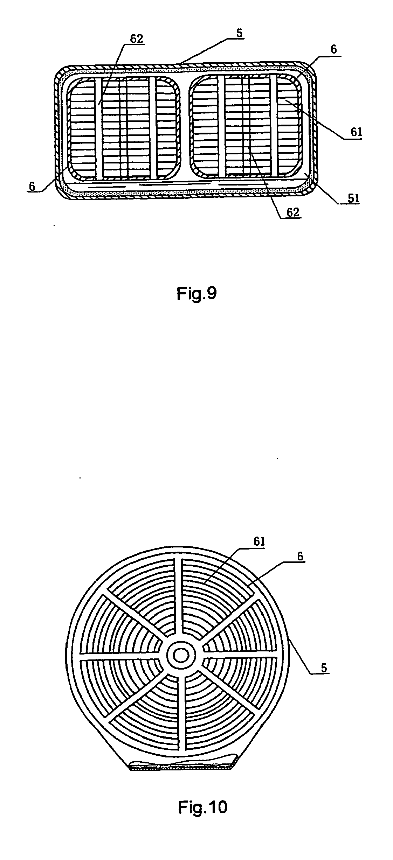

Fig. 9 shows an embodiment having two tubular thin-walled fluid channels provided by the present invention. The two tubular thin-walled fluid channels are formed in rectangle according to the shape of the enclosure 5. The shapes of end panels (not shown) are same as the shape formed between the two tubular thin-walled fluid channels 6 and the enclosure 5, and the method of sealing is same as the above-described principle structure, so detailed description is not described any more.

In this embodiment, multiple thin-walled heat pipes 62 made of metal material are arranged inside the tubular thin-walled fluid channel 6. These thin-walled heat pipes 62 vertically pass through the thermal fins 61 and are fixedly attached to the thermal fins 61. The both ends of the thin-walled heat pipes 62 are fixed to the inner wall of the tubular thin-walled fluid channel 6 and their inner cavity are communicated with the sealed space 51. The establishment of thin-walled heat pipes 62 provides support for the densely arranged thermal fins 61, improves the strength of thermal fins 61, and at the same time increases the heat exchanging area, On the other hand, the establishment of thin-walled heat pipes 62 also increases the volume of the sealed space 51, which is more advantageous for the evaporated working liquid to transfer heat energy to the environmental and speeds up the rate of phase change from gas to liquid, and thus improves the heat transfer efficiency of the whole heat pipe radiator of the heat generating electronic component.

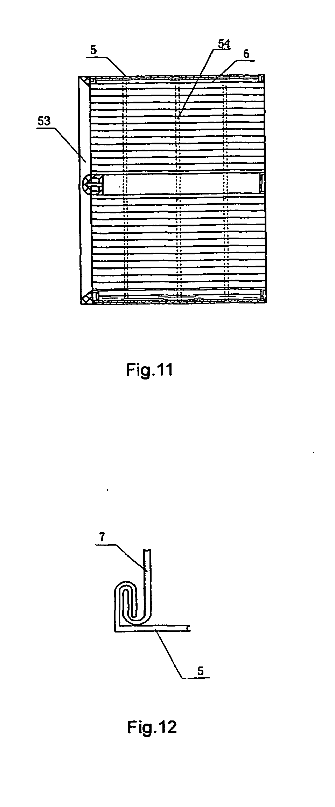

Fig. 10 shows a schematic view of a further embodiment of a circular enclosure according to the present invention. In this example, the enclosure 5 is circular. Its bottom is flat (for being tightly attached to the surface of the integrate circuit chip). There are 10 tubular thin-walled fluid channels like orange petals arranged in the enclosure 5. Inside the tubular thin-walled fluid channel 6, the thermal fins 61 are densely arranged in circular arc. This example has excellent heat transfer efficiency. An enhanced cooling fan can be easily mounted on the circular enclosure and further improves the heat transfer rate. In order to achieve better heat transfer efficiency of the cold flow produced by the enhanced cooling fan, a guiding cover 53, which is used for introduce the cooling flow into the tubular thin-walled fluid channels 6, is mounted at the edge of the enclosure 5. The shape of the guiding cover 53 is similar to the enclosure 5 (as shown in Fig. 11). The inner side of the guiding cover 53 is a taper, i.e. the outer side is larger than the inner side. When the enhanced cooling fan is mounted outside the guiding cover 53 and delivers gas into the tubular thin-walled fluid channels 6, the taper inclined surface the guiding cover 53 can introduce cold gas into the tubular thin-walled fluid channels 6 as much as possible, which improves the efficiency of the heat transfer.

In this embodiment, in order to improve the structural strength of the entire radiator, three layers of reinforcement plates 54 are provide in the sealed space 51. The shape of these reinforcement plates 54 is same as that of orthogonal projection of the sealed space 51 against the enclosure 5 in the axial direction, i.e. same as the shape of the end panels 7. These reinforcement plates are arranged parallel to the end panels 7. Holes or gaps, which are provided for the flow of working fluid, but not affect circular movement of the phase change, are formed in the reinforcement plates 54.

In the embodiment of the above described heat pipe radiators for heat generating electronic components, the connection manner in Fig. 12 may be applied for the connection of the edges of the end panels with the edges of enclosure and with the edges of tubular thin-walled fluid channels (only the connection of the end panels to the enclosure shown in Fig). In this figure, the edge of end panel 7 is connected with the enclosure 5 by saddle joint, and the connection portions can be fixed by welding or adhering. The edges of end panels and tubular thin-walled fluid channels may also be connected in this manner. This connection is suitable for producing some heat pipe radiators for heat generating electronic components on an industrial scale. Moreover, larger sealed space is obtained in this manner, which is advantageous for the evaporation heat transfer.

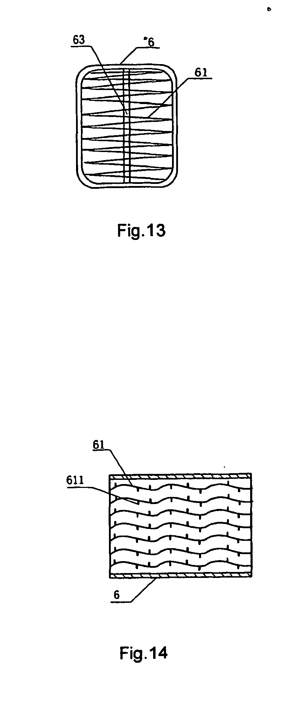

The high efficiency of heat transfer of the present invention is also attributed to the optimization of the arrangement of thermal fins. The embodiments made from sheet metals of the present invention are shown in Fig.13.

Fig.13 shows an embodiment of the arrangement of thermal fins, in which the thermal fins 61 are made from the thin metal plate. The metal plate is continuously bended according to "Z" shape, and the thermal fins 61 are formed as thermal fins groups arranged in the tubular thin-walled fluid channel 6. A support plate 63 is provided between the thermal fins 61. This support plate 63 is made of metal and vertically passes through the thermal fins 61. The support plate 63 is fixed to the inner wall of the tubular thin-walled fluid channel 6 by welding top and bottom edges to the tubular thin-walled fluid channel 6. At the same time, the thermal fins 61 and support plate 63 is tightly connected by welding. Also, the bended ends of the thermal fins 61 are tightly connected with the inner wall of tubular thin-walled fluid channel 6 by welding. Thus, the thinness of the metal plate used to manufacture thermal fins can be as small as possible, without affecting the structural strength. Actually, the support plate 63 serves as a rib. In addition, because the support plate 63 is made of metal material and tightly connected with thermal fins 61, the efficiency of heat transfer is improved. Moreover, the thin thermal fins 61 further increase the effective heat transfer area.

Fig. 14 shows another embodiment of arrangement of the thermal fins. In this embodiment, thermal fins 61 made of sheet metals are wavy. They are arranged in parallel as a group and fixed to the inner wall of tubular thin-walled fluid channel 6. Each thermal fin is provided with multiple upright thorns 611. When cooling fluid flows through the tubular thin-walled fluid channel 6, the wavy thermal fins can make the cooling fluid fluctuant, prolong the contact time with the surfaces of thermal fins 61 and enhance capability of the heat transfer. At the same time, the upright thorns 611 can bring on the phenomenon of turbulent flow of cooling fluid, so that the cooling fluid can take more heat energy away.

In addition, some perforated holes for cold liquid passing through may be formed at the surfaced of thermal fins 61, so as to increase the efficiency of heat transfer as much as possible.

The two embodiments shown in Fig. 13 and Fig. 14 not only increase the area for heat transfer, but also provide space volume for cooling fluid to flow through in the tubular thin-walled fluid channel 6 . This space volume is often more than two times of the volume of sealed space. When heat pipe radiator of small volume used for components is desired, and the heat transfer area can not be enlarged limitlessly, the space volume for the cooling fluid to flow through can be increased as much as possible.

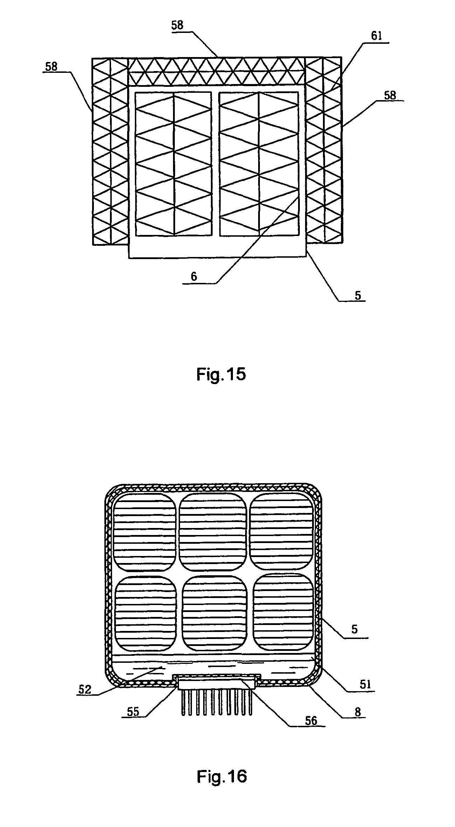

When a space is big enough for heat transfer, another embodiment is provided by this invention, in which outside tubular fluid channels are attached to the outer side of the enclosure, as shown in Fig. 15.

In this Figure, three outside tubular fluid channels 58, made of material of excellent thermal conductivity, are fixedly mounted to the surfaces of the enclosure 5. The axial line of outside tubular fluid channels 58 is parallel to that of tubular thin-walled fluid channel 6. Thermal fins 61 are fixedly attached to the inner wall of outside tubular fluid channels 58. The arrangement of thermal fins 61 in outside tubular fluid channels 58 may adopt the manner as shown in Fig. 13, but parallel arrangement is also applicable. Thermal fins 61 absorb the heat energy of the outside surface of the enclosure 5 and significantly increase the heat transfer area of the enclosure 5, thus speed up the heat transfer rate and improve the heat transfer efficiency.

The enclosure of this invention can be made of metal material, and engineering plastic can also be used to produce the enclosure in quantity. When the engineering plastic is adopted, a heat conductive plate may be fixed to the enclosure, and get the heat conductive plate and the surface of heat generating electronic components integrated closely, in order to decrease the thermal resistance.

The heat conductive plate can be directly embedded in the enclosure, or allows a concave formed at the surface of the enclosure and the heat plates as the bottom surface, so that the heat plates are stretched into the sealed space and thus decrease the thermal resistance of conventional manner of direct contact. Fig. 16 shows an embodiment, in which the heat conductive plate is stretched into the sealed space. It can be seen from this figure that a concave 55, which can be embedded in an integrated circuit ship (CPU chip), is formed at the bottom of enclosure 5. The bottom surface of the concave 55 is the heat conductive plate 56. With the arrangement that the concave 55 located in the sealed space, the wick 8 is coated on the other surface and the entire concave 55 is located in the sealed space, the heat energy generated by the chip can be easily dissipated through the working liquid and extremely high efficiency of heat transfer is achieved.

The heat conductive plate 56 can be made from metal plate with excellent thermal conductivity, and can also be made from organic soft plate. The organic soft plate is able to tightly contact the surface of chips under installation pressure, and allows the heat energy to be rapidly transferred to the working fluid 52.

The heat conductive plate 56 and the concave 55 can be made in rectangle, circle or the like, according to the shape of heat generating electric component. Moreover, multiple concaves 55 can be formed in the enclosure 5, resulting in a heat pipe radiator of heat generating electronic component used for integrated heat transfer.

In order to completely eliminate the thermal resistance of heat generating electronic components during the thermal transfer, the heat generating part thereof can be directly immersed in the working fluid. The embodiment is described hereinafter.

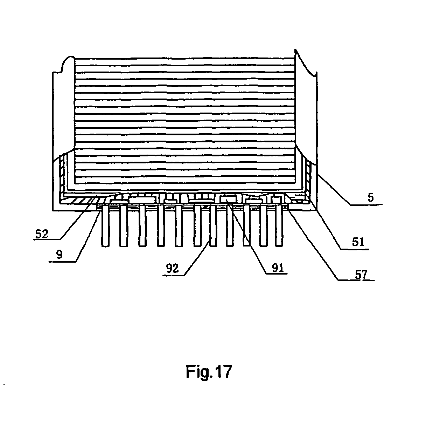

Referring to Fig. 17, a hole 57 that holds a base plate 9 for components with size matching for the hole is formed at the bottom of the enclosure 5. The base plate 9 for components is hermetically connected with enclosure at the edge thereof. An Integrated electronic circuit 91 is provided at the surface of base plate for components 9 located in the sealed space 51. Multiple pins 92 of the integrated electronic circuit 91 can be protruded out of the base plate for components 9, and can be directly attached to a circuit board. The Integrated electronic circuit 91 is directly immersed in the working liquid 52 and the wick 8 is coated on the surface of the integrated electronic circuit 91. In this embodiment, the wick 8 can be made of electrically insulated non-metal material, and the working liquid is also electrically insulated. The wick 8 and the working liquid are chemically and electronically compatible with the integrated electronic circuit 91.

The other structures of this embodiment are same as that of the above described embodiments. The heat generated by the integrated electronic circuit 91 during using is directly transferred to the working liquid 52, which maximizes the heat transfer efficiency and thus eliminates the phenomenon of thermal resistance. During the production, firstly the integrated electronic circuit 91 can be formed at the surface of the base plate for components 9, and then the base plate for components 9 is hermetically fixed to the hole 57 formed on the enclosure 5 in advance. Finally, the sealed space 51 is evacuated and infused with working fluid 52.

With the above described manners, multiple base plates for components 9 can be installed at the surface of enclosure 5, resulting in a heat pipe radiator for integrated heat generating electronic components having multiple chips.

This embodiment can also be used to produce high power transistor element with its own heat pipe for heat generating electronic components and heat pipe radiators for integrated heat generating electronic components having multiple transistor elements. During production, only the P-N junctions are fixedly attached to the surface of base plates for components 9, so as to allow the heat generated by P-N junctions can be rapidly dissipated through the working liquid 52. Thus, the phenomenon that the heat energy can only be exported by the insulated material of junction base and that the destruction of transistors resulted from bad heat transfer is eliminated.

## Claims

1. A heat pipe radiator for heat generating electronic components comprising a tubular enclosure (5), a tubular thin-walled fluid channel (6) arranged in the enclosure (5) with the edge hermetically connected with that of the enclosure (5) by an end panel (7);
thermal fins (61) are fixedly arranged in the tubular thin-walled fluid channel (6);
**characterized in that**
a sealed space (51) is formed between the inner wall of the enclosure (5) and the outside of the tubular thin-walled fluid channel (6); and the sealed space (51) is evacuated and infused with a working fluid (52) which is vaporizable when it meets heat and condensable when it meets cold;
the internal surface of the enclosure in the sealed space (51) is coated with a wick (8) which has interstices capable of causing capillary forces to absorb liquid and allowing the liquid to spread on the wick (8);
an infusion hole (71) used to evacuate the sealed space (51) and infuse the working liquid (52) is provided on the end panel or the enclosure (5), and it is sealed off after the sealed space (51) is evacuated and infused with the working liquid (52),
some upright thorns for causing turbulent flow of cooling fluid are vertically arranged at a surface of the thermal fins;
wherein the wick (8) is formed by stacking multilayer fiber woven meshes or multilayer metal meshes (81), or is plate-shaped with micro-pores (82) formed by powder sintering or the wick is strip-shaped made from metal or organic sheets by continuously and repeatedly folding or bending; pores (83) are formed at the surfaces of the sheets which are attached to the inner wall of the enclosure by welding or adhering.

2. The heat pipe radiator for heat generating electronic components as claimed in claim 1, wherein the enclosure (5) is a rectangular, circular or hexagonal tube made of the material with excellent thermal conductivity.

3. The heat pipe radiator for heat generating electronic components as claimed in claim 1, wherein the strip-shaped wick is formed by repeatedly folding or bending the sheets according to "U" shape, "V" shape or "Ω" shape, so that many grooves of "U" shape, "V" shape or "Ω" shape are formed in the strip-shaped wick.

4. The heat pipe radiator for heat generating electronic components as claimed in claim 3, wherein end surfaces of the grooves of "U" shape, "V" shape and "Ω" shape of the strip-shaped wick are sealed off.

5. The heat pipe radiator for heat generating electronic components as claimed in claim 1, wherein the pores (83) are rectangular or circular or protruding aperture openings and evenly arranged at the surface of the sheets.

6. The heat pipe radiator for heat generating electronic components as claimed in any one of claims 1-5, wherein the number of the tubular thin-walled fluid channels (6) is one or more; and the end panels (7) are hermetically connected to the edges of a plurality of tubular thin-walled fluid channels (6) and the edges of enclosure so that a communicated sealed space (51) is formed between the tubular thin-walled fluid channels (6) and the inner wall of the enclosure (5) and between the outsides of a plurality of tubular thin-walled fluid channels (6).

7. The heat pipe radiator for heat generating electronic components as claimed in claim 6, wherein the tubular thin-walled fluid channels (6) are rectangular, circular or hexagonal tubes made of metal material with excellent thermal conductivity and the space volume in the tubular thin-walled fluid channels (6) for the cooling fluid to flow through is 2 times larger than that of the sealed space (51).

8. The heat pipe radiator for heat generating electronic components as claimed in claim 6, wherein one or more support rods or support plates made of metal material are further arranged in the tubular thin-walled fluid channels (6); the support rods or support plates (63) pass through the thermal fins (61) and are fixed to the inner wall of the tubular thin-walled fluid channels (6); the thermal fins (61) are tightly connected with the support rods or support plates (63).

9. The heat pipe radiator for heat generating electronic components as claimed in claim 6, wherein one or more thin-walled heat pipes (62) made of metal material are further arranged in the tubular thin-walled fluid channels (6); the thin-walled heat pipes (62) pass through the thermal fins (61) and are tightly connected to the thermal fins (61), with their both ends fixed to the inner walls of the tubular thin-walled fluid channels (6) and communicated with the sealed space (51).

10. The heat pipe radiator for heat generating electronic components as claimed in claim 1, wherein flanges useful for welding or adhering to the inner wall of the enclosure (5) and the outer surface of the tubular thin-walled fluid channels (6) are protuberantly formed at the circumferential edges of the end panels (7).

11. The heat pipe radiator for heat generating electronic components as claimed in claim 1, wherein the edges of the end panels are connected with the edge of the enclosure (5) and/or the edges of the tubular thin-walled fluid channels (6) by crook saddle joints and the connection portions are fixed by welding or adhering.

12. The heat pipe radiator for heat generating electronic components as claimed in claim 1, wherein one or more layers of reinforcement plates (54) for enhancing the strength of the enclosure which do not hinder the working liquid's operation are adhered to or welded on the sealed space; the shape of the reinforcement plates (54) is same as the end panels (7) and parallel to the end panels (7).

13. The heat pipe radiator for heat generating electronic components as claimed in claim 1, wherein the thermal fins (61) are wavy and made of metal pieces.

14. The heat pipe radiator for heat generating electronic components as claimed in claim 1, wherein the thermal fins (61) are formed as thermal fins groups by continuously folding metal sheets according to "Z" shape.

15. The heat pipe radiator for heat generating electronic components as claimed in claim 1 or 13 or 14, wherein multiple penetrating holes for the cooling fluid to flow through are formed at the surface of the thermal fins (61).

16. The heat pipe radiator for heat generating electronic components as claimed in any one of claims 1-5, wherein a guiding cover (53) for introducing the cooling fluid into the tubular thin-wall fluid channels (6) is further suitably mounted at the edge of enclosure (5); and the shape of the guiding cover (53) is same as that of the enclosure (5) or the tubular thin-wall fluid channels (6).

17. The heat pipe radiator for heat generating electronic components as claimed in claim 1, wherein outer tubular thin-walled fluid channels (58) made of material with excellent heat conductivity are further fixedly attached to the outside surface of the enclosure (5); the axial lines of the outer tubular thin-wall fluid channels (58) are parallel to the axial lines of the tubular thin-wall fluid channel (6); and thermal fins (61) are fixed to the internal walls of the outer tubular thin-walled fluid channels (58).

18. The heat pipe radiator for heat generating electronic components as claimed in claim 1 or 17, wherein one or more heat conductive plates (56), which are able to be tightly attached to the heat transfer surface of the outer heat generating electronic components, are fixedly arranged on the enclosure (5); the heat conductive plates (56) are embedded into the surface of the enclosure (5) or a bottom surface of a special concave (55) formed at the surface of the enclosure (5) for embedding into the heat transfer surfaces of heat generating electronic components (91).

19. The heat pipe radiator for heat generating electronic components as claimed in claim 18, wherein the heat conductive plates (56) are rectangular or circular and made of metal plates or organic soft plates with excellent thermal conductivity.

20. The heat pipe radiator for heat generating electronic components as claimed in claim 1 or 17, wherein one or more holes are further formed at the enclosure (5) and hold base plates for components with size matching for the holes; the base plates for components are hermetically connected with the enclosure at the circumferential edge thereof; the surfaces of the base plates located in the sealed space (51) are provided with inner chips of integrated electronic circuits (91) or electronic components; pins (92) of inner chips of the integrated electronic circuits (91) or electronic components are arranged on the outer surfaces of the base plates for components (9) located outside the enclosure (5); the wick (8) is electrically insulated and applied on the inner chips of the integrated electronic circuits (91) or electronic components; and the working liquid (52) is an electrical insulating material and chemically and electrically compatible with the material of inner chips of the integrated electronic circuits or the electronic components (91).

## Patentansprüche

1. Heatpipe-Kühler für wärmeerzeugende elektronische Bauteile, mit einem rohrförmigen Gehäuse (5) und einem rohrförmigen dünnwandigen Fluidkanal (6), der in dem Gehäuse (5) angeordnet ist, wobei dessen Rand durch eine Abschlusswand (7) hermetisch dicht mit dem Rand des Gehäuses (5) verbunden ist,
wobei Kühlrippen (61) fest in dem rohrförmigen dünnwandigen Fluidkanal (6) angeordnet sind,
**dadurch gekennzeichnet, dass**
ein abgedichteter Raum (51) zwischen der Innenwand des Gehäuses (5) und der Außenseite des rohrförmigen dünnwandigen Fluidkanals (6) gebildet ist; und der abgedichtete Raum (51) entleert und mit einem Arbeitsfluid (52) gefüllt wird, welches verdampfbar ist, wenn es auf Wärme trifft, und kondensierbar ist, wenn es auf Kälte trifft;
wobei die Innenfläche des Gehäuses in dem abgedichteten Raum (51) mit einem Drän (8) beschichtet ist, der Poren aufweist, die in der Lage sind, kapillare Kräfte dazu zu bringen, Flüssigkeit zu absorbieren, und es der Flüssigkeit zu ermöglichen, sich auf dem Drän (8) auszubreiten,
wobei eine Einfüllöffnung (71), die dazu verwendet wird, den abgedichteten Raum (51) zu entleeren und mit der Arbeitsflüssigkeit (52) zu befüllen, auf der Abschlusswand oder dem Gehäuse (5) angeordnet ist, welche abgedichtet ist, nachdem der abgedichtete Raum (51) entleert und mit der Arbeitsflüssigkeit (52) befüllt wurde, wobei auf einer Oberfläche der Kühlrippen einige aufrechtstehende Spitzen zur Erzeugung einer turbulenten Strömung des Kühlfluids senkrecht angeordnet sind;
wobei der Drän (8) gebildet wird durch Stapeln mehrschichtiger gewebter Fasergewebe oder mehrschichtiger Metallgewebe (81), oder wobei der Drän plattenförmig ist mit durch Pulversintern geformten Mikroporen (82), oder wobei der Drän streifenförmig ist, hergestellt aus Metall oder organischen Platten durch kontinuierliches und wiederholtes Falten oder Biegen, wobei Poren (83) an den Oberflächen der Platten ausgebildet sind, die durch Schweißen oder Verkleben an der Innenwand des Gehäuses befestigt sind.

2. Heatpipe-Kühler für wärmeerzeugende elektronische Bauteile nach Anspruch 1, wobei das Gehäuse (5) ein rechteckiges, kreisförmiges oder hexagonales Rohr ist, welches aus einem Material hergestellt ist, welches eine exzellente thermische Leitfähigkeit aufweist.

3. Heatpipe-Kühler für wärmeerzeugende elektronische Bauteile nach Anspruch 1, wobei der streifenförmige Drän geformt ist durch wiederholtes Falten oder Biegen der Platten in "U"-Form, "V"-Form oder "Ω"-Form, sodass viele Rillen in "U"-Form, "V"-Form oder "Ω"-Form in dem streifenförmigen Drän gebildet werden.

4. Heatpipe-Kühler für wärmeerzeugende elektronische Bauteile nach Anspruch 3, wobei Endflächen der Rillen in "U"-Form, "V"-Form und "Ω"-Form des streifenförmigen Dräns abgedichtet sind.

5. Heatpipe-Kühler für wärmeerzeugende elektronische Bauteile nach Anspruch 1, wobei die Poren (83) rechteckige oder kreisförmige oder vorstehende Durchlassöffnungen sind, die auf der Oberfläche der Platten gleichmäßig verteilt angeordnet sind.

6. Heatpipe-Kühler für wärmeerzeugende elektronische Bauteile nach einem der Ansprüche 1 bis 5, wobei die Anzahl der rohrförmigen dünnwandigen Fluidkanäle (6) eins oder mehr beträgt, und die Abschlussplatten (7) hermetisch dicht mit den Rändern einer Mehrzahl von rohrförmigen dünnwandigen Fluidkanälen (6) und den Rändern des Gehäuses verbunden sind, so dass ein verbundener abgedichteter Raum (51) zwischen den rohrförmigen dünnwandigen Fluidkanälen (6) und der Innenwand des Gehäuses (5) und zwischen den Außenseiten einer Mehrzahl von rohrförmigen dünnwandigen Fluidkanälen (6) gebildet wird.

7. Heatpipe-Kühler für wärmeerzeugende elektronische Bauteile nach Anspruch 6, wobei die rohrförmigen dünnwandigen Fluidkanäle (6) rechteckige, kreisförmige oder hexagonale Rohre aus Metall sind mit einer exzellenten thermischen Leitfähigkeit, und wobei das Raumvolumen in den rohrförmigen dünnwandigen Fluidkanälen (6), durch die das Kühlfluid durchströmen soll, zweimal größer ist als das des abgedichteten Raums (51).

8. Heatpipe-Kühler für wärmeerzeugende elektronische Bauteile nach Anspruch 6, wobei eine oder mehrere Trägerstangen oder Trägerplatten aus Metall ferner in den rohrförmigen dünnwandigen Fluidkanälen (6) angeordnet sind, wobei die Trägerstangen oder Trägerplatten (63) durch die Kühlrippen (61) hindurchgehen und an der Innenwand der rohrförmigen dünnwandigen Fluidkanäle (6) befestigt sind, wobei die Kühlrippen (61) fest mit den Trägerstangen oder Trägerplatten (63) verbunden sind.

9. Heatpipe-Kühler für wärmeerzeugende elektronische Bauteile nach Anspruch 6, wobei eine oder mehrere dünnwandige Heatpipes (62) aus Metall ferner in den rohrförmigen dünnwandigen Fluidkanälen (6) angeordnet sind, wobei die dünnwandigen Heatpipes (62) durch die Kühlrippen (61) hindurchgehen und fest mit den Kühlrippen (61) verbunden sind, wobei deren beide Enden an den Innenwänden der rohrförmigen dünnwandigen Fluidkanäle (6) befestigt und mit dem abgedichteten Raum (51) verbunden sind.

10. Heatpipe-Kühler für wärmeerzeugende elektronische Bauteile nach Anspruch 1, wobei Flansche zum Verschweißen oder Kleben an der Innenwand des Gehäuses (5) und der Außenfläche der rohrförmigen dünnwandigen Fluidkanäle (6) vorstehend an den Umfangswänden der Abschlusswände (7) ausgebildet sind.

11. Heatpipe-Kühler für wärmeerzeugende elektronische Bauteile nach Anspruch 1, wobei die Ränder der Abschlusswände mit dem Rand des Gehäuses (5) und/oder den Rändern der rohrförmigen dünnwandigen Fluidkanäle (6) durch Biegesattelgelenke verbunden sind, und die Verbindungsbereiche durch Verschweißen oder Kleben befestigt sind.

12. Heatpipe-Kühler für wärmeerzeugende elektronische Bauteile nach Anspruch 1, wobei eine oder mehrere Schichten verstärkter Platten (54) zum Erhöhen der Festigkeit des Gehäuses, die die Arbeitsflüssigkeit nicht behindern, an den abgedichteten Raum geklebt oder geschweißt sind, wobei die Form der Verstärkungsplatten (54) die gleiche ist wie die der Abschlusswände (7) und wobei diese Platten parallel zu den Abschlusswänden (7) verlaufen.

13. Heatpipe-Kühler für wärmeerzeugende elektronische Bauteile nach Anspruch 1, wobei die Kühlrippen (61) wellenförmig sind und aus Metallteilen hergestellt sind.

14. Heatpipe-Kühler für wärmeerzeugende elektronische Bauteile nach Anspruch 1, wobei die Kühlrippen (61) durch kontinuierliches Falten von Metallblechen in "Z"-Form als Kühlrippengruppen geformt sind.

15. Heatpipe-Kühler für wärmeerzeugende elektronische Bauteile nach Anspruch 1 oder 13 oder 14, wobei eine Mehrzahl von Durchgangslöchern, durch die das Kühlfluid fließt, in der Fläche der Kühlrippen (61) ausgebildet ist.

16. Heatpipe-Kühler für wärmeerzeugende elektronische Bauteile nach einem der Ansprüche 1 bis 5, wobei eine Führungsabdeckung (53) zum Einführen des Kühlfluids in die rohrförmigen dünnwandigen Fluidkanäle (6) zusätzlich geeignet an dem Rand des Gehäuses (5) montiert ist, und die Form der Führungsabdeckung (53) die gleiche wie die des Gehäuses (5) oder der rohrförmigen dünnwandigen Fluidkanäle (6) ist.

17. Heatpipe-Kühler für wärmeerzeugende elektronische Bauteile nach Anspruch 1, wobei die äußeren rohrförmigen dünnwandigen Fluidkanäle (58) aus einem Material mit exzellenter Wärmeleitfähigkeit hergestellt sind, und ferner fest an der äußeren Oberfläche des Gehäuses (5) befestigt sind, wobei die Axiallinien der äußeren rohrförmigen dünnwandigen Fluidkanäle (58) parallel zu den Axiallinien des rohrförmigen dünnwandigen Fluidkanals (6) verlaufen, und Kühlrippen (61) an den Innenwänden der äußeren rohrförmigen dünnwandigen Fluidkanäle (58) befestigt sind.

18. Heatpipe-Kühler für wärmeerzeugende elektronische Bauteile nach Anspruch 1 oder 17, wobei eine oder mehrere wärmeleitende Platten (56), die an der Wärmeübertragungsfläche der äußeren wärmeerzeugenden elektronischen Bauteile fest befestigt werden können, fest an dem Gehäuse (5) angeordnet sind, wobei die wärmeleitenden Platten (56) in die Oberfläche des Gehäuses (5) oder eine Bodenfläche einer speziellen Höhlung (55) eingebettet sind, die an der Oberfläche des Gehäuses (5) ausgeformt ist, um darin die Wärmeübertragungsflächen der wärmeerzeugenden elektronischen Bauteile (91) einzubetten.

19. Heatpipe-Kühler für wärmeerzeugende elektronische Bauteile nach Anspruch 18, wobei die wärmeleitenden Platten (56) rechteckig oder kreisförmig sind und aus Metallplatten oder weichen organischen Platten mit exzellenter thermischer Leitfähigkeit hergestellt sind.

20. Heatpipe-Kühler für wärmeerzeugende elektronische Bauteile nach Anspruch 1 oder 17, wobei eine oder mehrere Öffnungen in dem Gehäuse (5) ausgebildet sind und Basisplatten für Bauelemente mit einer Größe, die zu den Öffnungen passt, halten, wobei die Basisplatten für Bauteile hermetisch dichtend mit dem Gehäuse an dessen Umfangsrand verbunden sind, wobei die Oberflächen der Basisplatten, die in dem abgedichteten Raum (51) angeordnet sind, mit inneren Chips integrierter elektronischer Schaltkreise (91) oder elektronischen Bauteilen versehen sind; Stifte (92) innerer Chips der integrierten elektronischen Schaltkreise (91) oder elektronische Bauteile sind auf den äußeren Oberflächen der Basisplatten für Bauteile (9) angeordnet, die außerhalb des Gehäuses (5) gelegen sind, wobei der Drän (8) elektrisch isoliert ist und an den inneren Chips der integrierten elektronischen Schaltkreise (91) oder den elektronischen Bauteilen angelegt ist, und wobei die Arbeitsflüssigkeit (52) ein elektrisch isolierendes Material ist, welches chemisch und elektrisch mit dem Material der inneren Chips der integrierten elektronischen Schaltkreise oder der elektronischen Bauteile (91) kompatibel ist.

## Revendications

1. Radiateur à caloduc pour composants électroniques générant de la chaleur comprenant une enceinte (5) tubulaire, un canal (6) pour fluide tubulaire à paroi mince agencé dans l'enceinte (5) avec le bord hermétiquement connecté avec celui de l'enceinte (5) par un panneau (7) d'extrémité ;
des ailettes (61) thermiques sont agencées de façon fixe dans le canal (6) pour fluide tubulaire à paroi mince ;
**caractérisé en ce que**
un espace (51) scellé est formé entre la paroi intérieure de l'enceinte (5) et l'extérieur du canal (6) pour fluide tubulaire à paroi mince ; et l'espace (51) scellé est vidé et perfusé avec un fluide (52) de travail qui est vaporisable lorsqu'il rencontre de la chaleur et condensable lorsqu'il rencontre du froid ;
la surface interne de l'enceinte dans l'espace (51) scellé est revêtue d'une mèche (8) qui a des interstices aptes à faire en sorte que des forces capillaires absorbent un liquide et à permettre que le liquide soit étalé sur la mèche (8) ;
un trou (71) de perfusion utilisé pour faire le vide dans l'espace (51) scellé et perfuser le liquide (52) de travail est prévu sur le panneau d'extrémité ou l'enceinte (5), et il est scellé après que l'espace (51) scellé a été vidé et perfusé avec le liquide (52) de travail,
quelques pointes dressées pour causer un écoulement turbulent de fluide de refroidissement sont agencées verticalement au niveau d'une surface des ailettes thermiques ;
dans lequel la mèche (8) est formée en empilant des mailles en fibres tissées multicouche ou des mailles (81) métalliques multicouche, ou bien est en forme de plaque avec des micropores (82) formés par frittage de poudre, ou bien la mèche est en forme de bandes constituées de feuilles métalliques ou organiques par pliage ou cintrage continu et répété ; des pores (83) sont formés au niveau des surfaces des feuilles qui sont fixées à la paroi intérieure de l'enceinte par soudure ou collage.

2. Radiateur à caloduc pour composants électroniques générant de la chaleur selon la revendication 1, dans lequel l'enceinte (5) est un tube rectangulaire, circulaire ou hexagonal constitué du matériau avec une excellente conductivité thermique.

3. Radiateur à caloduc pour composants électroniques générant de la chaleur selon la revendication 1, dans lequel la mèche en forme de bandes est formée par pliage ou cintrage répété des feuilles à une forme en « U », une forme en « V » ou une forme en « Ω », de telle sorte que de nombreuses rainures en forme en « U », en forme en « V » ou en forme en « Ω » sont formées dans la mèche en forme de bandes.

4. Radiateur à caloduc pour composants électroniques générant de la chaleur selon la revendication 3, dans lequel des surfaces d'extrémité des rainures en forme en « U », en forme en « V » et en forme en « Ω » de la mèche en forme de bandes sont scellées.

5. Radiateur à caloduc pour composants électroniques générant de la chaleur selon la revendication 1, dans lequel les pores (83) sont des ouvertures rectangulaires ou circulaires ou à ouverture en saillie et agencés régulièrement à la surface des feuilles.

6. Radiateur à caloduc pour composants électroniques générant de la chaleur selon l'une quelconque des revendications 1 à 5, dans lequel le nombre des canaux (6) pour fluide tubulaires à paroi mince est un ou plus ; et les panneaux (7) d'extrémité sont hermétiquement connectés aux bords d'une pluralité de canaux (6) pour fluide tubulaires à paroi mince et aux bords de l'enceinte de telle sorte qu'un espace (51) scellé communiquant est formé entre les canaux (6) pour fluide tubulaires à paroi mince et la paroi intérieure de l'enceinte (5) et entre les extérieurs d'une pluralité de canaux (6) pour fluide tubulaires à paroi mince.

7. Radiateur à caloduc pour composants électroniques générant de la chaleur selon la revendication 6, dans lequel les canaux (6) pour fluide tubulaires à paroi mince sont des tubes rectangulaires, circulaires ou hexagonaux constitués d'un matériau métallique avec une excellente conductivité thermique et le volume d'espace dans les canaux (6) pour fluide tubulaires à paroi mince pour l'écoulement du fluide de refroidissement est 2 fois plus grand que celui de l'espace (51) scellé.

8. Radiateur à caloduc pour composants électroniques générant de la chaleur selon la revendication 6, dans lequel une ou plusieurs tige(s) de support ou plaque(s) de support constituée(s) d'un matériau métallique est/sont en outre agencée(s) dans les canaux (6) pour fluide tubulaires à paroi mince ; les tiges de support ou plaques de support (63) passent à travers les ailettes (61) thermiques et sont fixées à la paroi intérieure des canaux (6) pour fluide tubulaires à paroi mince ; les ailettes (61) thermiques sont étroitement connectées avec les tiges de support ou plaques de support (63).

9. Radiateur à caloduc pour composants électroniques générant de la chaleur selon la revendication 6, dans lequel un ou plusieurs caloduc(s) (62) à paroi mince constitué(s) d'un matériau métallique est/sont en outre agencé(s) dans les canaux (6) pour fluide tubulaires à paroi mince ; les caloducs (62) à paroi mince passent à travers les ailettes (61) thermiques et sont étroitement connectés aux ailettes (61) thermiques, avec leurs deux extrémités fixées aux parois intérieures des canaux (6) pour fluide tubulaires à paroi mince et en communication avec l'espace (51) scellé.

10. Radiateur à caloduc pour composants électroniques générant de la chaleur selon la revendication 1, dans lequel des rebords utiles pour un soudage ou un collage à la paroi intérieure de l'enceinte (5) et la surface extérieure des canaux (6) pour fluide tubulaires à paroi mince sont formés de façon protubérante au niveau des bords circonférentiels des panneaux (7) d'extrémité.

11. Radiateur à caloduc pour composants électroniques générant de la chaleur selon la revendication 1, dans lequel les bords des panneaux d'extrémité sont connectés avec le bord de l'enceinte (5) et/ou les bords des canaux (6) pour fluide tubulaires à paroi mince par assemblages à dos d'âne courbe et les parties de connexion sont fixées par soudage ou collage.

12. Radiateur à caloduc pour composants électroniques générant de la chaleur selon la revendication 1, dans lequel une ou plusieurs couche(s) de plaques (54) de renfort pour améliorer la résistance de l'enceinte qui n'empêchent pas le fonctionnement du liquide de travail est/sont collée(s) ou soudée(s) sur l'espace scellé ; la forme des plaques (54) de renfort est la même que celle des panneaux (7) d'extrémité et parallèle aux panneaux (7) d'extrémité.

13. Radiateur à caloduc pour composants électroniques générant de la chaleur selon la revendication 1, dans lequel les ailettes (61) thermiques sont ondulées et constituées de pièces métalliques.

14. Radiateur à caloduc pour composants électroniques générant de la chaleur selon la revendication 1, dans lequel les ailettes (61) thermiques sont formées comme des groupes d'ailettes thermiques par pliage continu de feuilles métalliques à une forme en « Z ».

15. Radiateur à caloduc pour composants électroniques générant de la chaleur selon la revendication 1 ou 13 ou 14, dans lequel des trous multiples de pénétration pour l'écoulement du fluide de refroidissement sont formés à la surface des ailettes (61) thermiques.

16. Radiateur à caloduc pour composants électroniques générant de la chaleur selon l'une quelconque des revendications 1 à 5, dans lequel un couvercle (53) de guidage pour introduire le fluide de refroidissement dans les canaux (6) pour fluide tubulaires à paroi mince est en outre monté de façon appropriée au niveau du bord de l'enceinte (5) ; et la forme du couvercle (53) de guidage est la même que celle de l'enceinte (5) ou des canaux (6) pour fluide tubulaires à paroi mince.

17. Radiateur à caloduc pour composants électroniques générant de la chaleur selon la revendication 1, dans lequel des canaux (58) pour fluide extérieurs tubulaires à paroi mince constitués d'un matériau avec une excellente conductivité thermique sont en outre attachés de façon fixe à la surface extérieure de l'enceinte (5) ; les lignes axiales des canaux (58) pour fluide extérieurs tubulaires à paroi mince sont parallèles aux lignes axiales du canal (6) pour fluide tubulaire à paroi mince ; et des ailettes (61) thermiques sont fixées aux parois internes des canaux (58) pour fluide extérieurs tubulaires à paroi mince.

18. Radiateur à caloduc pour composants électroniques générant de la chaleur selon la revendication 1 ou 17, dans lequel une ou plusieurs plaque(s) (56) thermo-conductrice(s), qui est/sont apte(s) à être étroitement fixée(s) à la surface de transfert de chaleur des composants électroniques externes générant de la chaleur, est/sont agencée(s) de façon fixe sur l'enceinte (5) ; les plaques (56) thermo-conductrices sont intégrées dans la surface de l'enceinte (5) ou une surface de fond d'un concave (55) spécial formé à la surface de l'enceinte (5) pour intégration dans les surfaces de transfert de chaleur de composants électroniques (91) générant de la chaleur.

19. Radiateur à caloduc pour composants électroniques générant de la chaleur selon la revendication 18, dans lequel les plaques (56) thermo-conductrices sont rectangulaires ou circulaires et constituées de plaques métalliques ou de plaques organiques souples avec une excellente conductivité thermique.

20. Radiateur à caloduc pour composants électroniques générant de la chaleur selon la revendication 1 ou 17, dans lequel un ou plusieurs trou(s) est/sont en outre formé(s) au niveau de l'enceinte (5) et maintient/maintiennent des plaques de base pour des composants avec une taille correspondant aux trous ; les plaques de base pour composants sont hermétiquement connectées avec l'enceinte au niveau du bord circonférentiel de celle-ci ; les surfaces des plaques de base situées dans l'espace (51) scellé sont prévues avec des puces internes de circuits électroniques intégrés (91) ou de composants électroniques ; des broches (92) de puces internes des circuits électroniques intégrés (91) ou des composants électroniques sont agencées sur les surfaces extérieures des plaques de base pour des composants (9) situés à l'extérieur de l'enceinte (5) ; la mèche (8) est électriquement isolée et appliquée sur les puces internes des circuits électroniques intégrés (91) ou des composants électroniques ; et le liquide (52) de travail est un matériau d'isolation électrique et chimiquement et électriquement compatible avec le matériau de puces internes des circuits électroniques intégrés ou des composants électroniques (91).
